# EUROPEAN PATENT APPLICATION

(11) **EP 4 542 270 A1**
(43) Date of publication of application: **23.04.2025**
(21) Application number: 24206884.9
(22) Date of filing: 16.10.2024
(51) Int. Cl.: G02B 5/30, G02F 1/01, G02F 1/13, G02F 1/1335, G02F 1/1347

(54) **ELLIPTICALLY POLARIZING PLATE AND IMAGE DISPLAY DEVICE**

(30) Priority: 19.10.2023 JP 2023180449
(71) Applicant: NITTO DENKO CORPORATION, Ibaraki-shi Osaka 567-8680 (JP)
(72) Inventor: YAMAOKA, Yohei, Ibaraki-shi, Osaka, 567-8680 (JP); NAGAHATA, Keiji, Ibaraki-shi, Osaka, 567-8680 (JP)
(74) Representative: Hoffmann Eitle

(57) **Abstract**

Disclosed is an elliptically polarizing plate (101) comprising a polarizing plate (1) and a retardation layer (3). The polarizing plate includes a polarizer (10) having a thickness of 15 µm or more and transparent protective films (11 and 12) disposed on both principal surfaces of the polarizer. The retardation layer is bonded onto one protective film of the polarizing plate. The elliptically polarizing plate is a sized piece having an irregularly shape that is not a rectangle in its plan view. An angle between an absorption axis direction of the polarizer and a slow axis direction of the retardation layer is 10 to 80°. The retardation layer satisfies Re(450) < Re(550) < Re(650), wherein Re(450) represents a front retardation at a wavelength of 450 nm, Re(550) represents a front retardation at a wavelength of 550 nm, and Re(650) represents a front retardation at a wavelength of 650 nm, and the retardation layer includes at least one aligned liquid crystal layer in which liquid crystal molecules are homogeneously-aligned.

## Description

### TECHNICAL FIELD

The present invention relates to an elliptically polarizing plate including a polarizing plate and a retardation layer arranged on one principal surface of the polarizing plate. The present invention also relates to and an image display device including an image display cell and the elliptically polarizing plate arranged on a surface of the image display cell.

### BACKGROUND ART

Mobile phones, smartphones, car navigation devices, monitors for personal computers, televisions, and the like are display devices including an image display element. Examples of the image display element include a liquid crystal display and an organic light emitting diode (OLED) display. In the liquid crystal display, a polarizing plate is arranged on a viewing-side surface of an image display cell under its display principle. In the OLED display, an elliptically polarizing plate (*e.g.,* a circularly polarizing plate in which a polarizing plate and a quarter wave plate are laminated) is arranged on a viewing-side surface of an image display cell to prevent a situation in which external light is reflected by a metal electrode (cathode) so that a mirror surface is visually recognized.

In recent years, OLED displays that can be thinned or curved have actively been used, and OLED displays have come to be used for instruments arranged in instrument panels and consoles of cars. Optical films, such as polarizing plates, used for these display devices may be processed to have a shape that is not a rectangle (irregularly shape) in their plan views (see, for example, Patent Document 1).

### PRIOR ART DOCUMENT

Patent Document 1: JP 2022-47611 A

### SUMMARY OF THE INVENTION

### PROBLEMS TO BE SOLVED BY THE INVENTION

On-vehicle image display devices are required to change little in their display properties even in a harsh environment such as high temperature or high humidity. However, an image display device, in which a circularly polarizing plate subjected to irregularly-shaped-processing is arranged on the surface of an OLED cell, has a problem that when such an image display device is exposed to a high-temperature environment for a long time, coloring of reflected light is likely to visually be recognized around an irregularly-shaped-processed portion such as a notch or a cutout.

In view of the above circumstances, it is an object of the present invention to provide an elliptically polarizing plate that makes it possible to prevent a change in visibility around an irregularly-shaped-processed portion.

### MEANS FOR SOLVING THE PROBLEMS

The present invention relates to a sized piece of an elliptically polarizing plate having an irregularly shape that is not a rectangle in its plan view. The elliptically polarizing plate includes: a polarizing plate in which transparent protective films are disposed on both surfaces of a polarizer having a thickness of 15 µm or more; and a retardation layer bonded onto the transparent protective film arranged on one surface side of the polarizing plate. An angle between an absorption axis direction of the polarizer and a slow axis direction of the retardation layer is 10 to 80°. The retardation layer satisfies Re(450) < Re(550) < Re(650), wherein Re(450) represents a front retardation at a wavelength of 450 nm, Re(550) represents a front retardation at a wavelength of 550 nm, and Re(650) represents a front retardation at a wavelength of 650 nm.

The retardation layer includes at least one aligned liquid crystal layer in which liquid crystal molecules are homogeneously aligned. The retardation layer may include two or more aligned liquid crystal layers, and at least one of them is a homogeneously-aligned liquid crystal layer. The retardation layer may include two or more homogeneously-aligned liquid crystal layers. The retardation layer may include an aligned liquid crystal layer in which liquid crystal molecules are homogeneously aligned and an aligned liquid crystal layer in which liquid crystal molecules are homeotropically aligned.

The elliptically polarizing plate according to the present invention is suitable for use in forming an on-vehicle image display device. An embodiment of the elliptically polarizing plate according to the present invention is arranged on a viewing-side surface of an image display cell. The image display cell may be an OLED cell.

### EFFECTS OF THE INVENTION

In the elliptically polarizing plate according to the present invention, front retardation of the retardation layer changes little even when exposed to a high-temperature environment for a long time, and therefore a change in visibility around an irregularly-shaped-processed portion can be prevented.

### BRIEF DESCRIPTION OF THE DRAWINGS

FIGS. 1A, 1B, 2C, 2D, 2E, 2F, 2G, 2H, 2I, 2J, 2K, 3L and 3M are schematic plan views for illustrating planar shapes of irregularly-shaped elliptically polarizing plates.
FIGS. 4 to 6 are cross-sectional views of an elliptically polarizing plate according to an embodiment of the present invention.
FIG. 7 is a sectional view showing an example of stacking configuration of an image display device.
FIG. 8 is a diagram for illustrating a retardation change at an irregularly-shaped-processed portion.
FIG. 9 is a diagram showing planar shape of an irregularly-shaped circularly polarizing plate produced in an example and measurement positions of a front retardation.
FIGS. 10A and 10B are graphs obtained by plotting reflection hue of circularly polarizing plates of Comparative Example 1 and Example 2, respectively.

### MODE FOR CARRYING OUT THE INVENTION

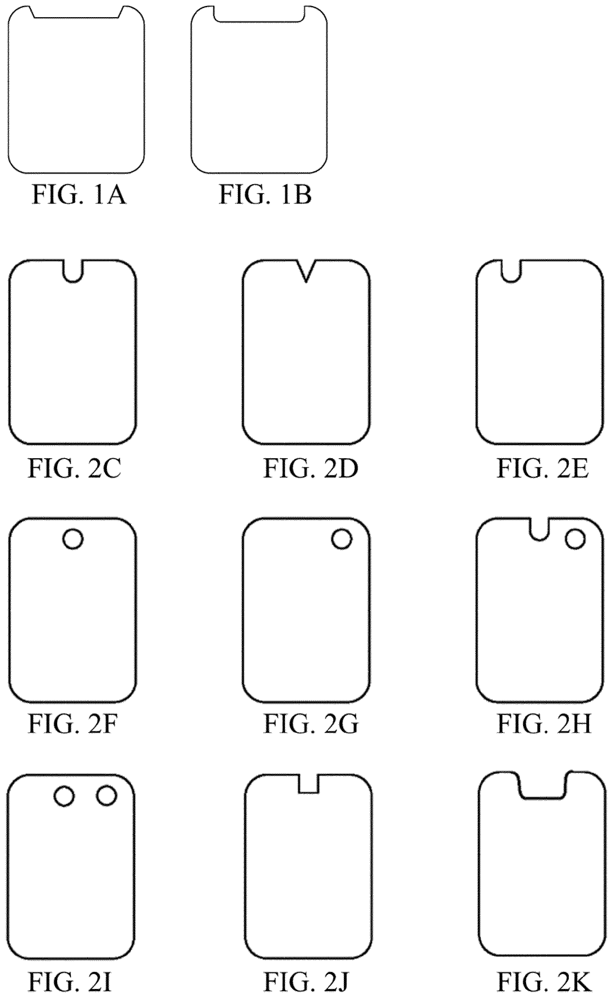

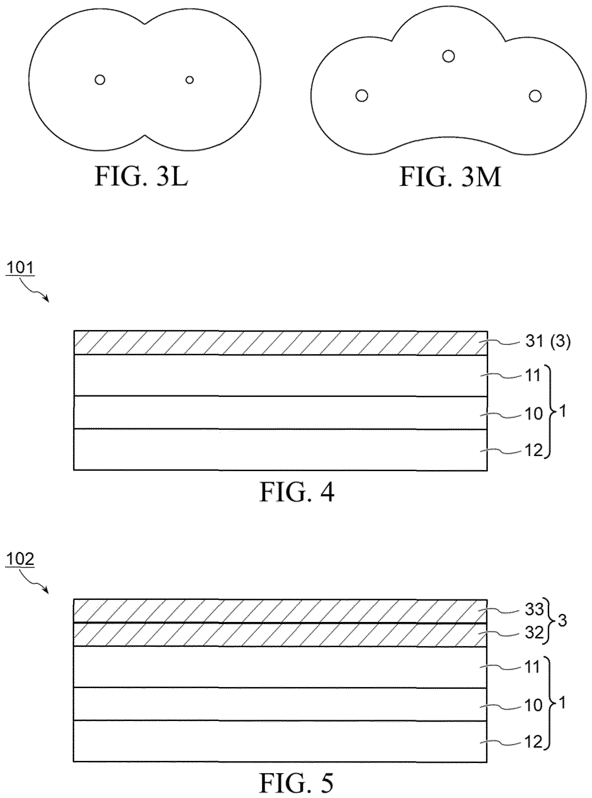

The present invention relates to a sized piece of an elliptically polarizing plate having a shape that is not a rectangle (irregularly shape) in its plan view. FIGS. 1A, 1B, 2C, 2D, 2E, 2F, 2G, 2H, 2I, 2J, 2K, 3L and 3M are plan views for illustrating planar shapes of irregularly-shaped elliptically polarizing plates. FIGS. 4 to 6 are cross-sectional views of an elliptically polarizing plate according to an embodiment of the present invention.

The elliptically polarizing plate according to the present invention includes: a polarizing plate 1 in which transparent protective films 11 and 12 are bonded to both surfaces of a polarizer 10; and a retardation layer 3 disposed on the transparent protective film 11. An angle between the absorption axis direction of the polarizer 10 and the slow axis direction of the retardation layer 3 is 10 to 80°.

### [Shape of elliptically polarizing plate]

The term "irregularly-shaped" herein means that the elliptically polarizing plate has a shape other than a rectangle in its plan view. The irregularly-shaped elliptically polarizing plate typically has an irregularly-shaped-processed portion formed by irregularly-shaped-processing. Such irregularly-shaped elliptically polarizing plates include an elliptically polarizing plate having a profile shape that is not a rectangle due to an irregularly-shaped-processed portion placed at its outer edge, a rectangular elliptically polarizing plate having an irregularly-shaped-processed portion in an area away from its outer edge, and an elliptically polarizing plate having irregularly-shaped-processed portions both at its outer edge and in an area away from the outer edge.

Examples of the irregularly shape (irregularly-shaped-processed portion) include, as shown in FIGS. 1A and 1B and FIGS. 2C to 2K, one having a cutting-processed portion that appears as a recessed portion in a plan view and one having a through-hole. Typical examples of the recessed portion include a shape similar to a boat shape, a rectangle, a round shape similar to a bathtub shape, a V-shaped notch, and a U-shaped notch. Another example of the irregularly shape (irregularly-shaped-processed portion) is, as shown in FIG. 3L and 3M, a shape corresponding to the meter panel of a car. This shape is formed to have an arc-shaped outer edge along the rotation direction of a meter needle, and the outer edge includes V-shaped portions (each having round-shaped portions) projected inwardly in the planar direction.

The irregularly shape (irregularly-shaped-processed portion) is not limited to the examples shown in FIGS. 1 to 3. For example, the through-hole may have an elliptical shape, a triangular shape, a quadrangular shape, a pentagonal shape, a hexagonal shape, or an octagonal shape. The through-hole is formed in any appropriate position depending on the intended use. The position of the through-hole is not limited. A plurality of through-holes may be formed in one elliptically polarizing plate.

The elliptically polarizing plate may have a shape obtained by combining a plurality of shapes formed by irregularly-shaped-processing. For example, a through-hole may be formed in any position in the elliptically polarizing plate having a profile shape shown in FIG. 1A or FIG. 1B, or a V-shaped notch or a U-shaped notch may be formed in any position in the elliptically polarizing plate having a profile shape shown in FIG. 3L or FIG. 3M.

When the irregularly-shaped-processed portion has a round-shaped portion, the radius of curvature thereof is, for example, 0.2 mm or more and may be 0.5 mm or more, 1 mm or more, or 2 mm or more. The radius of curvature of the irregularly-shaped-processed portion is, for example, 10 mm or less and may be 7 mm or less or 5 mm or less.

The irregularly-shaped-processed portion can be formed by any appropriate method. Examples of the processing method include cutting with an end mill, punching with a Thomson blade or a pinnacle blade, and cutting by laser irradiation.

Such an irregularly-shaped elliptically polarizing plate is suitable for use in on-vehicle image display devices such as car meter panels and mobile image display devices such as smartphones, tablet PCs and smartwatches. As will be described later in detail, the elliptically polarizing plate according to the present invention is particularly suitable for use in on-vehicle image display devices.

### [Stacking configuration of elliptically polarizing plate]

FIG. 4 is a cross-sectional view of an elliptically polarizing plate according to an embodiment of the present invention. An elliptically polarizing plate 101 includes a polarizing plate 1 in which transparent protective films 11 and 12 are disposed on both surfaces of a polarizer 10; and a retardation layer 3 disposed on one surface side of the polarizing plate 1.

### <Polarizing Plate>

Examples of the polarizer 10 of the polarizing plate 1 include one obtained by adsorbing a dichroic substance such as iodine or a dichroic dye to a hydrophilic polymer film such as a polyvinyl alcohol-based film or an ethylene/vinyl acetate copolymer-based partially saponified film and uniaxially stretching the resultant and a polyene-based oriented film such as a dehydrated product of polyvinyl alcohol or a dehydrochlorinated product of polyvinyl chloride.

The polarizer 10 is preferably an iodine-containing polyvinyl alcohol (PVA)-based film for its high polarization degree and high durability at high-temperatures. The material of the PVA-based film used for the polarizer is polyvinyl alcohol or a derivative thereof. Examples of the derivative of polyvinyl alcohol include polyvinyl formal, polyvinyl acetal, and a derivative obtained by modifying polyvinyl alcohol with an olefin such as ethylene or propylene, an unsaturated carboxylic acid such as acrylic acid, methacrylic acid, or crotonic acid, an alkyl ester thereof, or acrylamide. The polyvinyl alcohol to be generally used has a polymerization degree of about 1000 to 10000 and a saponification degree of about 80 to 100 mol%.

The PVA-based film is subjected to iodine staining and stretching to obtain a polarizer. In the process of producing a polarizer, treatment such as water washing, swelling, or cross-linking may be performed, if necessary. The stretching may be performed either before or after the iodine staining or may be performed at the same time with the staining. The stretching may be performed either in air (dry stretching) or in water or an aqueous solution containing boric acid, potassium iodide, or the like (wet stretching), or dry stretching and wet stretching may be performed in combination.

The polarizer 10 has a thickness of 15 µm or more. When having a large thickness, the polarizer tends to have improved high-temperature durability and is therefore suitable for use in cars. From the viewpoint of thickness reduction, the thickness of the polarizer 10 is preferably 100 µm or less and may be 60 µm or less, 50 µm or less, or 40 µm or less.

### <Transparent protective film>

The polarizing plate 1 includes transparent protective films 11 and 12 disposed on both principal surfaces of the polarizer 10. Since the transparent protective films are bonded to both surfaces of the polarizer 10, a change in optical properties resulting from, for example, a dimensional change of the polarizer at high temperatures tends to be prevented.

The material of the transparent films 11 and 12 used as polarizer protective films is preferably a thermoplastic resin excellent in transparency, mechanical strength, and heat stability. Specific examples of such a thermoplastic resin include cellulose-based resins such as triacetyl cellulose, polyester-based resins, polyethersulfone-based resins, polysulfone-based resins, polycarbonate-based resins, polyamide-based resins, polyimide-based resins, polyolefin-based resins, (meth)acryl-based resins, cyclic polyolefin-based resins (norbornene-based resins), polyarylate-based resins, polystyrene-based resins, polyvinyl alcohol-based resins, and mixtures thereof.

The transparent film 11 disposed on one of the surfaces of the polarizer 10 and the transparent film 12 disposed on the other surface of the polarizer 10 may be films composed of the same resin material or films composed of different resin materials.

The thickness of each of the transparent films 11 and 12 is not limited, but is preferably about 5 to 100 µm, more preferably 10 to 80 µm from the viewpoints of, for example, strength, workability such as handleability, and thinness.

### <Adhesive>

The polarizer 10 and each of the transparent protective films 11 and 12 are preferably bonded together with an appropriate adhesive layer (not shown) being interposed therebetween. An adhesive to be used may be any one of various adhesives such as a water-based adhesive, a solvent-based adhesive, a hot-melt adhesive, and an active energy ray-curable adhesive. Among them, a water-based adhesive or an active energy ray-curable adhesive is preferred because the thickness of the adhesive layer can be reduced. The material of the adhesive is not limited as long as it is optically transparent, and examples of such a material include epoxy-based resins, silicone-based resins, acryl-based resins, polyurethane, polyamide, polyether, and polyvinyl alcohol. The thickness of the adhesive layer is preferably 5 µm or less, more preferably 0.01 to 3 µm, still more preferably 0.05 to 2 µm.

### <Retardation layer>

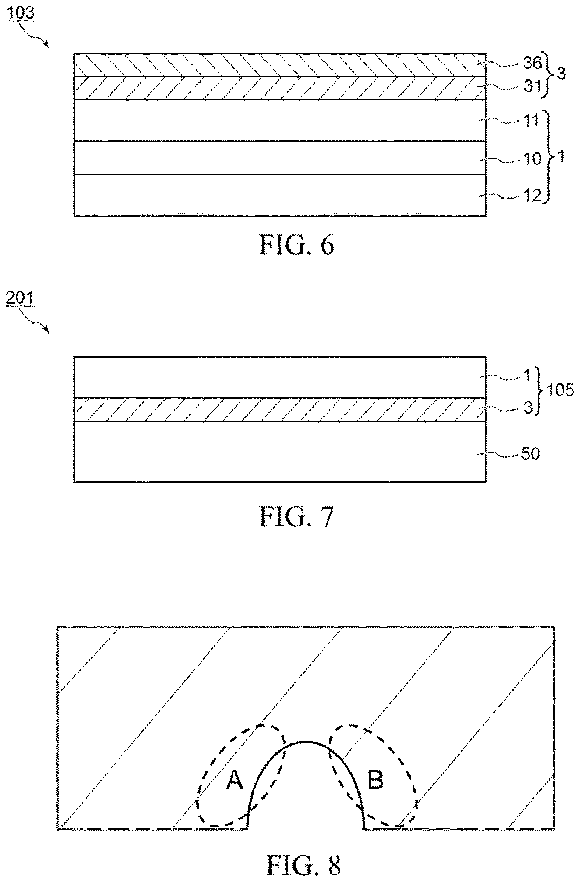

The elliptically polarizing plate 101 includes a retardation layer 3 disposed on the transparent protective film 11 of the polarizing plate 1. The retardation layer 3 may be constituted from one layer or may be a laminate of a plurality of retardation layers as shown in FIG. 5 or 6.

The retardation layer 3 is arranged so that an angle between the absorption axis direction of the polarizer 10 and the slow axis direction of the retardation layer 3 is 10 to 80°. Since the retardation layer 3 is arranged so that an angle between the absorption axis direction of the polarizer and the slow axis direction of the retardation layer is neither parallel nor perpendicular, linearly polarized light emitted from the polarizer 10 is converted to elliptically polarized light when passing through the retardation layer 3, and therefore a laminate of the polarizing plate 1 and the retardation layer 3 functions as an elliptically polarizing plate.

The retardation layer 3 satisfies Re(450) < Re(550) < Re(650), wherein Re(450) represents a front retardation at a wavelength of 450 nm, Re(550) represents a front retardation at a wavelength of 550 nm, and Re(650) represents a front retardation at a wavelength of 650 nm. Since the retardation layer 3 has properties such that the retardation is larger at a longer wavelength (so-called "reverse wavelength dispersion"), the elliptically polarizing plate can emit uniform elliptically polarized light in a wide wavelength range of visible light.

The Re(450)/Re(550) of the retardation layer 3 is less than 1, preferably 0.65 to 0.99, more preferably 0.70 to 0.95, still more preferably 0.75 to 0.90 and may be 0.80 to 0.85. The Re(650)/Re(550) of the retardation layer 3 is larger than 1, preferably 1.01 to 1.35, more preferably 1.03 to 1.30, still more preferably 1.05 to 1.25, and may be 1.10 to 1.20.

An embodiment of the elliptically polarizing plate 101 is a circularly polarizing plate in which the retardation layer 3 is a quarter wave plate and an angle between the absorption axis direction of the polarizer 10 and the slow axis direction of the retardation layer 3 is about 45°. The circularly polarizing plate including the reverse wavelength dispersion retardation layer 3 is small in difference between the front retardation of the retardation layer and a quarter wavelength over a wide wavelength range of visible light, and therefore circularly polarized light can be obtained in a wider wavelength band. When a broadband circularly polarizing plate is disposed on the surface of an OLED display, excellent anti-reflection properties such that reflected light is less likely to be colored can be achieved.

In order to allow the elliptically polarizing plate to function as a circularly polarizing plate intended to prevent the reflection of an OLED display, the front retardation Re(550) of the retardation layer 3 at a wavelength of 550 nm is preferably 100 to 180 nm, more preferably 110 to 170 nm, still more preferably 120 to 150 nm and may be 125 to 145 nm. The angle ψ between the absorption axis direction of the polarizer 10 and the slow axis direction of the retardation layer 3 is preferably 40 to 50° and may be 43 to 47° or 44 to 46°.

When the retardation layer 3 is a laminate of a plurality of retardation layers and the in-plane slow axis directions of the retardation layers are not parallel to each other, an angle ψ calculated from the relational expression between the angle θ of a rotating analyzer and the intensity of transmitted light I(θ) determined by elliptical polarization measurement of the elliptically polarizing plate by a rotating analyzer method and the front retardation Re(550) are preferably within their respective ranges described above. Hereinafter, the angle ψ determined by elliptical polarization measurement and the front retardation are sometimes referred to as "apparent placement angle" and "apparent front retardation", respectively.

The retardation layer 3 includes at least one aligned liquid crystal layer in which liquid crystal molecules are homogeneously aligned. As in the case of the elliptically polarizing plate 101 shown in FIG. 4, when the retardation layer 3 is constituted from one retardation layer 31, the retardation layer 31 is an aligned liquid crystal layer in which liquid crystal molecules are homogeneously aligned.

The homogeneously-aligned liquid crystal layer is a positive A plate in which liquid crystal molecules are aligned along the slow axis direction, the positive A plate having refractive index anisotropy such that a refractive index nx in the in-plane slow axis direction (liquid crystal alignment direction), a refractive index ny in the in-plane fast axis direction, and a refractive index nz in the thickness direction satisfy nx > ny ≈ nz. The homogeneously-aligned liquid crystal layer is formed by, for example, applying a liquid crystal composition containing a liquid crystal compound onto a supporting substrate, homogeneously aligning the liquid crystal compound, and then fixing the state of alignment.

Examples of the liquid crystal compound include a rod-like liquid crystal compound and a disk-like liquid crystal compound. The liquid crystal compound is preferably a rod-like liquid crystal compound because homogeneous alignment is easily achieved by an alignment regulating force of the supporting substrate. The rod-like liquid crystal compound may be either a main chain-type liquid crystal or a side chain-type liquid crystal. The rod-like liquid crystal compound may be either a liquid crystal polymer or a polymer of a polymerizable liquid crystal compound. The liquid crystal compound after polymerization does not need to be liquid crystalline as long as the liquid crystal compound (monomer) before polymerization exhibits liquid crystallinity.

The liquid crystal compound is preferably a thermotropic liquid crystal that develops liquid crystallinity by heating. The thermotropic liquid crystal undergoes phase transition to a crystal phase, a liquid crystal phase, or an isotropic phase due to a temperature change. Examples of the rod-like liquid crystal compound having a thermotropic property include azomethines, azoxys, cyanobiphenyls, cyanophenyl esters, benzoic acid esters, cyclohexane carboxylic acid phenyl esters, cyanophenyl cyclohexanes, cyano-substituted phenyl pyrimidines, alkoxy-substituted phenyl pyrimidines, phenyldioxanes, tolans, and alkenyl cyclohexyl benzonitriles.

Examples of the polymerizable liquid crystal compound include a polymerizable liquid crystal compound capable of fixing the state of alignment of a rod-like liquid crystal compound using a polymer binder and a polymerizable liquid crystal compound having a polymerizable functional group capable of fixing the state of alignment of a liquid crystal compound by polymerization. Among them, a photopolymerizable liquid crystal compound having a photopolymerizable functional group is preferred.

The photopolymerizable liquid crystal compound (liquid crystal monomer) has a mesogen group and at least one photopolymerizable functional group in one molecule. The temperature at which the liquid crystal monomer exhibits liquid crystallinity (liquid crystal phase transition temperature) is preferably 40 to 200°C, more preferably 50 to 150°C, still more preferably 55 to 100°C.

Examples of the mesogen group of the liquid crystal monomer include cyclic structures such as a biphenyl group, a phenylbenzoate group, a phenylcyclohexane group, an azoxybenzene group, an azomethine group, an azobenzene group, a phenylpyrimidine group, a diphenylacetylene group, a diphenylbenzoate group, a bicyclohexane group, a cyclohexylbenzene group, and a terphenyl group. These cyclic units may have a substituent, such as a cyano group, an alkyl group, an alkoxy group, or a halogen group, at its terminal.

Examples of the photopolymerizable functional group include a (meth)acryloyl group, an epoxy group, and a vinyl ether group. Among them, a (meth)acryloyl group is preferred. The photopolymerizable liquid crystal monomer is preferably one having two or more photopolymerizable functional groups in one molecule. When the liquid crystal monomer containing two or more photopolymerizable functional groups is used, a crosslinking structure is introduced into a liquid crystal layer after photo-curing, which tends to improve the durability of the aligned liquid crystal layer.

The photopolymerizable liquid crystal monomer may be any appropriate liquid crystal monomer. Examples thereof include compounds disclosed in WO 00/37585, US Patent No. 5211877, US Patent No. 4388453, WO 93/22397, EP Patent No. 0261712, German Patent No. 19504224, German Patent No. 4408171, Great Britain Patent No. 2280445, JP 2017-206460A, WO 2014/126113, WO 2016/114348, WO 2014/010325, JP 2015-200877 A, JP 2010-31223 A, WO 2011/050896, JP 2011-207765 A, JP 2010-31223 A, JP 2010-270108 A, WO 2008/119427, JP 2008-107767 A, JP 2008-273925 A, WO 2016-125839, and JP 2008-273925 A. By selecting the liquid crystal monomer, developability of birefringence and wavelength dispersion of retardation can be adjusted, and a retardation layer 31 having wavelength dispersion represented by Re(450) < Re(550) < Re(650) can also be formed from one homogeneously-aligned liquid crystal layer.

The aligned liquid crystal layer is formed by mixing a liquid crystal monomer and various alignment controlling agents, a polymerization initiator, a levelling agent, etc. with a solvent to prepare a liquid crystal composition, applying the liquid crystal composition onto a supporting substrate, and aligning the liquid crystal compound. The use of a flexible film as a supporting substrate makes it possible to perform a series of processes from application of the liquid crystal composition onto the supporting substrate to photo-curing of the liquid crystal monomer and subsequent heating treatment in a roll-to-roll manner, thereby improving productivity.

The supporting substrate may have an aligning ability to align the liquid crystal compound in a predetermined direction. For example, the use of a stretched film as a supporting substrate makes it possible to homogeneously align the liquid crystal compound along the stretching direction of the stretched film. The stretched ratio of the stretched film is not limited as long as its aligning ability is exhibited, and is, for example, about 1.1 to 5 times. The stretched film may be a biaxially stretched film. Even when a biaxially stretched film is used, as long as the stretched ratio in the mechanical direction and the stretched ratio in the transverse direction are different, the liquid crystal compound can be aligned along a direction with a higher stretched ratio. The stretched film may be an obliquely stretched film. The use of an obliquely stretched film as a supporting substrate makes it possible to align the liquid crystal compound in a direction not parallel to both the longitudinal direction and the width direction of the supporting substrate.

The supporting substrate may include an alignment film provided on its surface where the aligned liquid crystal layer is to be formed. The alignment film may appropriately be selected, if necessary, depending on the type of liquid crystal compound, the material of the supporting substrate, etc. As an alignment film for homogeneously aligning the liquid crystal compound in a predetermined direction, a polyimide- or polyvinyl alcohol-based alignment film subjected to rubbing treatment is suitably used. Alternatively, a photo-alignment film may be used. A resin film as a supporting substrate may be subjected to rubbing treatment without providing an alignment film.

When the liquid crystal compound is a thermotropic liquid crystal, the liquid crystal composition is applied onto a supporting substrate and heated to align the liquid crystal compound in a liquid crystal state. By heating a liquid crystal composition layer formed on the supporting substrate to form a liquid crystal phase, the liquid crystal compound is aligned. Specifically, after applied onto the supporting substrate, the liquid crystal composition is heated to a temperature equal to or higher than the N (nematic phase)-I (isotropic liquid phase) transition temperature of the liquid crystal composition to bring the liquid crystal composition into an isotropic liquid state. Then, the liquid crystal composition is gradually cooled, if necessary, so that a nematic phase appears. At this time, the liquid crystal composition is desirably maintained once at a temperature at which a liquid crystal phase appears to allow liquid crystal phase domains to grow to form a monodomain. Alternatively, after applied onto the supporting substrate, the liquid crystal composition is maintained for a certain time at a temperature in a temperature range where a nematic phase appears to align the liquid crystal compound in a predetermined direction.

The heating temperature at which the liquid crystal compound is aligned along a predetermined direction may appropriately be selected depending on the type of liquid crystal composition, and is usually about 40 to 200°C. If the heating temperature is excessively low, transition to a liquid crystal phase tends to be insufficient, and if the heating temperature is excessively high, alignment defects may increase. The heating time may be adjusted so that liquid crystal domains sufficiently grow, and is usually about 30 seconds to 30 minutes.

After the liquid crystal compound is aligned by heating, the liquid crystal composition layer is preferably cooled to a temperature equal to or lower than a glass transition temperature. A cooling method is not limited. For example, the liquid crystal composition may be transferred from a heating atmosphere to a room temperature atmosphere. Forced cooling such as air cooling or water cooling may be performed.

When the liquid crystal layer is irradiated with light, the photopolymerizable liquid crystal compound (liquid crystal monomer) is photocured in a state where it has liquid crystal regularity. The irradiation light is not limited as long as the photopolymerizable liquid crystal compound can be polymerized. Usually, ultraviolet light having a wavelength of 250 to 450 nm or visible light is used. When light polarized in a predetermined direction is used for photo-curing of the liquid crystal composition, the liquid crystal compound can be aligned along a predetermined direction. As described above, when the liquid crystal compound is aligned by the alignment regulating force of the supporting substrate, unpolarized light (natural light) may be used as irradiation light.

A polymer after photo-curing of the liquid crystal monomer by light irradiation is non-liquid crystalline, and therefore transition among a liquid crystal phase, a glass phase, and a crystal phase due to a temperature change does not occur. Therefore, the liquid crystal layer photo-cured in a state where the liquid crystal monomer is aligned along a predetermined direction is less likely to change in molecular alignment due to a temperature change. When all the positive A plates are homogeneously-aligned liquid crystal layers, a change in front retardation and the in-plane variation of front retardation caused by heating are reduced so that coloring of reflected light at an irregularly-shaped-processed portion tends to be reduced.

When the retardation layer 3 is constituted from one homogeneously-aligned liquid crystal layer 31, the aligned liquid crystal layer 31 satisfies Re(450) < Re(550) < Re(650), and an angle ψ between the absorption axis direction of the polarizer 10 and the slow axis direction of the homogeneously-aligned liquid crystal layer 31 (alignment direction of liquid crystal) is 10 to 80°. When the elliptically polarizing plate 101 is used as a circularly polarizing plate, Re(550) of the aligned liquid crystal layer 31 is preferably 100 to 180 nm, more preferably 110 to 170 nm, still more preferably 120 to 150 nm and may be 125 to 145 nm, and the angle ψ is preferably 40 to 50° and may be 43 to 47° or 44 to 46°.

As described above, the retardation layer 3 may be a laminate of two or more retardation layers. Examples of the elliptically polarizing plate in which the retardation layer 3 is a laminate of two or more retardation layers include one in which the retardation layer includes two (or more) positive A plates 32 and 33 as shown in FIG. 5 and one in which the retardation layer 3 includes a positive A plate 31 that is a homogeneously-aligned liquid crystal layer and a positive C plate 36 as shown in FIG. 6.

In an elliptically polarizing plate 102 shown in FIG. 5, the retardation layer 3 has a stacking configuration of two positive A plates 32 and 33. An example of the retardation layer 3 constituted from two positive A plates is one in which the retardation layer 32 positioned proximal to the polarizing plate 1 is a half wave plate and the retardation layer 33 positioned distal from the polarizing plate 1 is a quarter wave plate.

In such a stacking configuration, the half wave plate and the quarter wave plate are preferably arranged so that an angle between the slow axis direction of the half wave plate and the absorption axis direction of the polarizer is 75° ± 5° and an angle between the slow axis direction of the quarter wave plate and the absorption axis direction of the polarizer is 15° ± 5 °. As described above, when the retardation layers 32 and 33 and the polarizer 10 are arranged so that the angle between their respective optical axes is neither parallel nor perpendicular, the elliptically polarizing plate is allowed to function as a circularly polarizing plate over a wide wavelength range of visible light even when the retardation layers 32 and 33 do not have reverse wavelength dispersion.

The principle that circularly polarized light can be obtained in a wide wavelength band by stacking a polarizer and a plurality of retardation layers is as described in, for example, JP 10-63816 A using a Poincare sphere. The retardation layers are not limited to a combination of a half wave plate and a quarter wave plate and may be a laminate of three of more retardation layers. The placement angle of each of the retardation layers is not limited to the above as long as the angle between the slow axis direction of each of the retardation layers and the absorption axis direction of the polarizer is in the range of 10° to 80°.

When the retardation layer 3 includes a plurality of positive A plates, as described above, the apparent placement angle ψ is preferably 40 to 50° and may be 43 to 47° or 44 to 46°. The apparent front retardation Re(550) of the retardation layer 3 is preferably 100 to 180 nm, more preferably 110 to 170 nm, still more preferably 120 to 150 nm and may be 125 to 145 nm.

When the retardation layer 3 includes two or more positive A plates, at least one of the positive A plates is a homogeneously-aligned liquid crystal layer, and preferably, all the positive A plates are aligned liquid crystal layers. When the positive A plates are all homogeneously-aligned liquid crystal layers, the thickness of the retardation layer 3 can be reduced. Further, as described above, when all the positive A plates are homogeneously-aligned liquid crystal layers, a change in front retardation and the in-plane variation of front retardation caused by heating are reduced so that coloring of reflected light at an irregularly-shaped-processed portion tends to be reduced.

An example of the positive A plate other than the aligned liquid crystal layer is a film of a non-liquid crystalline resin material (polymer). Examples of the polymer include polycarbonate-based resins, polyester-based resins such as polyethylene terephthalate and polyethylene naphthalate, polyarylate-based resins, sulfone-based resins such as polysulfone and polyethersulfone, sulfide-based resins such as polyphenylene sulfide, polyimide-based resins, cyclic polyolefin-based (polynorbornene-based) resins, polyamide resins, polyolefin-based resins such as polyethylene and polypropylene, and cellulose esters.

In an elliptically polarizing plate 103 shown in FIG. 6, the retardation layer 3 has a stacking configuration of one positive A plate 31 and one positive C plate 36. The positive A plate 31 is a homogeneously-aligned liquid crystal layer.

The elliptically polarizing plate 103 shown in FIG. 6 corresponds to a configuration in which a positive C plate having refractive index anisotropy of nz > nx ≈ ny is laminated on the homogeneously-aligned liquid crystal layer 31 of the elliptically polarizing plate 101 shown in FIG. 4. When the positive C plate and the positive A plate 31 are stacked, the oblique direction retardation of the positive A plate is cancelled by the positive C plate, and therefore the retardation layer 3 that is a laminate of the positive A plate 31 and the positive C plate 36 has refractive index anisotropy of nx > nz > ny, and the retardation changes little depending on a viewing angle. The circularly polarizing plate including a retardation layer, which is a laminate of a positive A plate and a positive C plate, can reduce not only reflected light in front of a display but also reflected light in an oblique direction.

Examples of the positive C plate include a homeotropically-aligned liquid crystal layer in which a liquid crystal compound is homeotropically aligned and a film of a non-liquid crystalline resin material (polymer) having a negative intrinsic birefringence.

The polymer having a negative intrinsic birefringence refers to one having a relatively small refractive index in a direction in which the polymer is oriented by stretching or the like. Examples of the polymer having a negative intrinsic birefringence include polymers in which a chemical bond or a functional group having high polarization anisotropy, such as an aromatic group or a carbonyl group, is introduced into a side chain thereof, and specific examples thereof include acryl-based resins, styrene-based resins, maleimide-based resins, and fumaric acid ester-based resins.

A method for producing the resin film is not limited and may either be a solution method or a melting method. When the resin film is formed by a solution method, molecular chains of the polymer tend to be oriented in the in-plane direction. When molecular chains of the polymer having a negative intrinsic birefringence are oriented in the in-plane direction, the thickness-direction refractive index nz of a coating film is relatively smaller than the in-plane refractive index so that positive C plate properties having refractive index anisotropy (the thickness-direction retardation Rth is a negative value) of nz > nx ≈ ny appear. Further, when the film of a polymer having a negative intrinsic birefringence is biaxially stretched so that the front retardation becomes almost 0, a positive C plate whose front retardation is almost 0 is obtained. It should be noted that nx ≈ ny is not limited to a case where nx and ny are exactly the same as long as the front retardation Re(550) at a wavelength of 550 nm is 10 nm or less. The front retardation Re(550) of the positive C plate is preferably 5 nm or less and may be 3 nm or less or 1 nm or less.

From the viewpoint of reducing the thickness of the retardation layer, the positive C plate 36 is preferably a homeotropically-aligned liquid crystal layer. The homeotropically-aligned liquid crystal layer is formed by, for example, applying a liquid crystal composition containing a liquid crystal compound onto a supporting substrate, homeotropically aligning the liquid crystal compound, and then fixing the state of alignment. The details of the homeotropically-aligned liquid crystal layer can be found in, for example, JP 2008-216782 A.

The thickness-direction retardation Rth represented by Rth = (nx - nz) × d of the positive C plate 36 is smaller than 0. It should be noted that nx and nz are as described above and d represents a thickness. The thickness-direction retardation Rth of the positive C plate 36 is, for example, -30 to - 200 nm, preferably -50 to -150 nm. The sum of the thickness-direction retardation of the positive A plate 31 and the thickness-direction retardation of the positive C plate 36 is preferably 30 to 110 nm, more preferably 40 to 100 nm, still more preferably 50 to 90 nm.

FIG. 6 shows a configuration in which the retardation layer 31 positioned proximal to the polarizer 10 is a positive A plate constituted from a homogeneously-aligned liquid crystal layer, and the retardation layer 36 positioned distal from the polarizer 10 is a positive C plate. The positive C plate may be positioned proximal to the polarizer 10 so that the positive A plate is positioned distal from the polarizer 10. Alternatively, instead of the positive A plate 31 constituted from one homogeneously-aligned liquid crystal layer, a stacked retardation layer of positive A plates 32 and 33 may be used.

### [Elliptically polarizing plate]

The elliptically polarizing plate is formed by laminating the retardation layer 3 on the transparent protective film 11 disposed on one principal surface of the polarizing plate 1. The angle between the polarizer 10 of the polarizing plate 1 and the retardation layer 3 is as described above.

The polarizing plate 1 and the retardation layer 3 are preferably bonded together with an appropriate adhesive or pressure sensitive adhesive being interposed therebetween. As shown in FIG. 5 or FIG. 6, when the retardation layer 3 is a laminate of a plurality of retardation layers, a previously-prepared laminate of the plurality of retardation layers may be bonded to the polarizing plate or the plurality of retardation layers may be laminated one by one on the polarizing plate. The bonding between the retardation layers is performed using an appropriate adhesive or pressure sensitive adhesive. The retardation layer 3 may include a film or an alignment film used as a supporting substrate in forming the aligned liquid crystal layer.

The elliptically polarizing plate may have, in addition to the polarizing plate and the retardation layer, various optional layers. Examples of the optional layer include an anti-reflection layer, a pressure sensitive adhesive for bonding the elliptically polarizing plate and an image display cell or the like, and a surface protective film for protecting the surface of the elliptically polarizing plate.

As described above, the elliptically polarizing plate according to the present invention is subjected to irregularly-shaped-processing. From the viewpoint of productivity, it is preferred that the irregularly-shaped-processing is performed after respective layers constituting the elliptically polarizing plate are laminated.

### [Image Display Device]

FIG. 7 is a cross-sectional view of an example of stacking configuration of an image display device, in which the retardation layer 3-side surface of an elliptically polarizing plate 105 is bonded to the surface of an image display cell 50 with a pressure sensitive adhesive layer (not shown) being interposed therebetween. The aligned liquid crystal film may include two or more aligned liquid crystal layers. Examples of the image display cell 50 include liquid crystal cells and OLED cells. The elliptically polarizing plate according to the present invention can suitably be used as a circularly polarizing plate for blocking reflection of external light in an on-vehicle OLED display.

On-vehicle image display devices are required to change little in their display properties even when exposed to a high-temperature environment for a long time. When a circularly polarizing plate subjected to irregularly-shaped-processing is used for an OLED display, coloring of reflected light is likely to visually be recognized around an irregularly-shaped-processed portion such as a notch in a high-temperature environment. The reason for this has been studied and found that one of causes for visual recognition of coloring of reflected light is that in a high-temperature endurance test, the variation of a change in front retardation is large around the irregularly-shaped-processed portion.

FIG. 8 is an enlarged diagram of an irregularly-shaped-processed portion and its vicinity of an irregularly-shaped-processed circularly polarizing plate, in which oblique lines represent the slow axis direction of a retardation layer. When a conventional irregularly-shaped-processed circularly polarizing plate is subjected to a heat endurance test, the front retardation of region A in the drawing is larger than the front retardation of region B by 10 nm or more, and reflected light in region A in which the front retardation is relatively large is visually recognized as blue light and reflected light in region B in which the front retardation is relatively small is visually recognized as red light. When the irregularly-shaped-processed portion is a notch, the region A and the region B are close to each other, and therefore the difference in color is easily recognized.

When the elliptically polarizing plate is exposed to a high-temperature environment, stress is generated at the bonding interface between the layers due to difference in heat dimensional change among the polarizer, the transparent protective film and the retardation layer. The stress at the interface may cause a change in the retardation of the retardation layer. A stretched film tends to largely be shrunk by heating in its stretching direction. Therefore, in an elliptically polarizing plate in which a polarizer and a retardation layer are arranged so that an angle between the absorption axis direction of the polarizer and the slow axis direction of the retardation layer is neither parallel nor perpendicular, the polarizer (polarizing plate) and the retardation layer are different in the behavior of heat shrinkage, and thus a change in the retardation of the retardation layer caused by stress is likely to be large.

In a sized piece of an elliptically polarizing plate, stress is likely to be relaxed in the vicinity of the outer edge. However, the region A in which the slow axis direction of the retardation layer and the machining direction of the irregularly-shaped-processed portion (tangential direction to the outer edge) are almost parallel to each other and the region B in which the slow axis direction of the retardation layer and the machining direction of the irregularly-shaped-processed portion are almost perpendicular to each other are different in behavior of stress relaxation, and therefore a difference between changes in retardation caused by heating is considered to be large.

In the elliptically polarizing plate according to the present invention, the thickness of the polarizer 10 is as large as 15 µm or more, and the transparent protective films 11 and 12 are bonded to both surfaces of the polarizer 10, thereby reducing the dimensional change of the polarizing plate 1. Further, the positive A plate of the retardation layer 3 is a homogeneously-aligned liquid crystal layer, and therefore its dimensional change after heating is smaller than that of a stretched film, thereby reducing a change in the front retardation of the retardation layer 3 caused by heating. Further, the aligned liquid crystal layer cured in a state where the liquid crystal compound is aligned does not undergo phase transition due to a temperature change and the state of alignment is fixed, which is also considered as one of causes for reducing a retardation change caused by heating.

Since the retardation layer 3 of the elliptically polarizing plate according to the present invention includes a homogeneously-aligned liquid crystal layer, the variation of front retardation of the retardation layer after a heat endurance test is small even in a region with a small area, in which a change in machining angle is large, such as a round shaped notch or a V-shaped notch. Therefore, a difference in color is less likely to be recognized in the vicinity of an irregularly-shaped-processed portion, and display properties are excellent. Such an irregularly-shaped-processed elliptically polarizing plate can suitably be used for on-vehicle image display devices required to change little in properties in a high-temperature environment.

### EXAMPLES

Hereinafter, the present invention will be described in more detail with reference to examples and comparative examples, but the present invention is not limited to the following examples.

### [Comparative Example 1]

### <Preparation of polarizing plate>

Transparent protective films are bonded to both surfaces of a stretched polyvinyl alcohol polarizer having a thickness of 18 µm with the use of an ultraviolet-curable adhesive. As the transparent protective film bonded to one of the surfaces, a triacetyl cellulose film (total thickness 49 µm) having a 3-µm-thick hard coating layer formed on one surface thereof was used, and the other surface on which the hard coating layer was not provided was bonded to the polarizer. As the transparent protective film bonded to the other surface, a stretched film (thickness 30 µm) of a modified acrylic resin into which a lactone ring structure had been introduced was used.

### <Production of retardation layer>

### (Production of polycarbonate film)

In accordance with a method disclosed in Example 1 in Japanese Patent No. 5204200, a polycarbonate-based resin including a structural unit derived from isosorbide (37.1 mol%), a structural unit derived from 9,9-bis[4-(2-hydroxyethoxy)phenyl]fluorene (47.4 mol%), and a structural unit derived from 1,4-cyclohexane dimethanol (15.5 mol%) was produced, and a film of the polycarbonate-based resin was formed and stretched. This stretched polycarbonate film was a positive A plate having refractive index anisotropy of nx > ny = nz and had a thickness of 37 µm, an Re(450) of 123 nm, an Re(550) of 144 nm, and an Re(650) of 152 nm.

### (Production of homeotropically-aligned liquid crystal layer)

20 parts by weight of a side chain-type liquid crystal polymer represented by the following chemical formula (n = 0.35, shown as a block polymer for convenience) and having a weight-average molecular weight of 5000, 80 parts by weight of a polymerizable liquid crystal compound ("Paliocolor LC242" manufactured by BASF) exhibiting a nematic liquid crystal phase, and 5 parts by weight of a photopolymerization initiator ("Omnirad 907" manufactured by IGM Resins) were dissolved in 400 parts by weight of cyclopentanone to prepare a liquid crystalline composition.

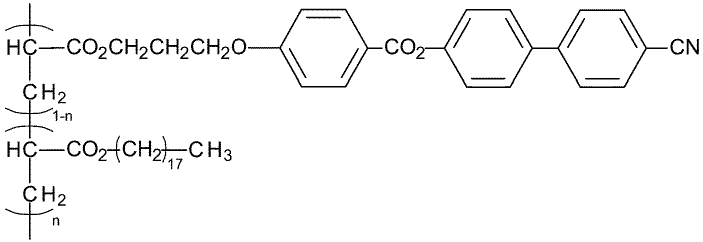

Onto the surface of a biaxially-stretched norbornene-based film ("ZeonorFilm" manufactured by Zeon Corporation, thickness: 52 µm, front retardation: 50 nm), the above liquid crystalline composition was applied by a bar coater so that the thickness thereof after drying was 1 µm, and was heated at 80°C for 2 minutes to align the liquid crystal and cooled to room temperature. Then, the resultant was irradiated with 700 mJ/cm² of ultraviolet light in a nitrogen atmosphere to photocure the liquid crystal monomer. In this way, a laminate A was obtained in which a homeotropically-aligned liquid crystal layer (thickness 3 µm) was formed on the film substrate. This homeotropically-aligned liquid crystal layer was a positive C plate having refractive index anisotropy of nz > nx = ny. Obtained homeotropically-aligned liquid crystal layer was transferred onto a glass plate to measure thickness-direction retardation. The thickness-direction retardation Rth(550) at a wavelength of 550 nm was 100 nm.

### (Preparation of adhesive)

50 parts by weight of unsaturated fatty acid hydroxyalkyl ester-modified ε-caprolactone (PLACCEL FA1DDM manufactured by Daicel Corporation), 25 parts by weight of acryloyl morpholine ("ACMO" manufactured by KJ Chemicals Corporation), 10 parts by weight of polypropylene glycol (n=3) diacrylate ("ARONIX M-220" manufactured by TOAGOSEI Co., Ltd.), 15 parts by weight of an epoxy group-containing acryl-based oligomer having a weight-average molecular weight of 2900 ("ARFON UG-4100" manufactured by TOAGOSEI Co., Ltd.), and 2 parts by weight of "Omnirad 907" and 2 parts by weight of "KAYACURE DETX-S" (manufactured by Nippon Kayaku Co., Ltd.) as a photopolymerization initiator were mixed to prepare an ultraviolet-curable adhesive composition A.

### (Bonding between polycarbonate film and homeotropically-aligned liquid crystal layer)

The polycarbonate film and the homeotropically-aligned liquid crystal layer-side surface of the laminate A were subjected to corona treatment, and then the adhesive composition A was applied and the polycarbonate film and the homeotropically-aligned liquid crystal layer were bonded together by a roll laminator. Then, the resultant was irradiated with 700 mJ/cm² of ultraviolet light using a UV curing device (V valve) manufactured by Fusion UV Systems to cure the adhesive. In this way, a laminated retardation layer was obtained in which the polycarbonate film and the homeotropically-aligned liquid crystal layer were bonded together with an adhesive layer being interposed therebetween.

### <Production of circularly polarizing plate>

The acryl-based-film-side surface of the polarizing plate was bonded to the polycarbonate film-side surface of the laminated retardation layer with a 20-µm-thick acryl-based pressure sensitive adhesive sheet being interposed therebetween. An angle between the absorption axis direction of the polarizer and the stretching direction (slow axis direction) of the polycarbonate film was set to 45°. Then, the film substrate was removed by peeling from the surface of the homeotropically-aligned liquid crystal layer, and a 23-µm-thick acryl-based pressure sensitive adhesive sheet was bonded to the exposed surface of the homeotropically-aligned liquid crystal layer. In this way, a pressure sensitive adhesive-equipped circularly polarizing plate was obtained in which a pressure sensitive adhesive sheet was disposed on a laminate (circularly polarizing plate) wherein the circularly polarizing plate includes a stretched polycarbonate film laminated on a polarizing plate with a pressure sensitive adhesive layer being interposed therebetween and a homeotropically-aligned liquid crystal layer laminated on the stretched polycarbonate film with an adhesive layer being interposed therebetween.

### <Processing of circularly polarizing plate>

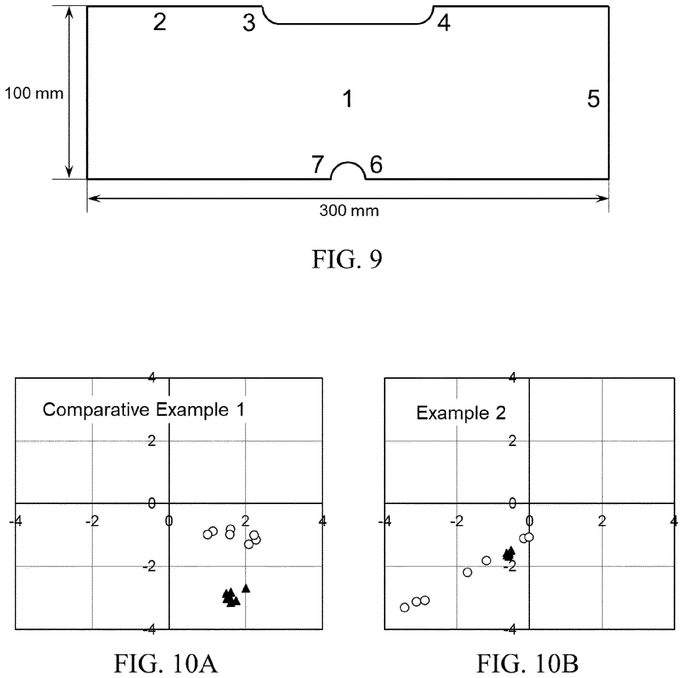

The above pressure sensitive adhesive-equipped circularly polarizing plate was punched out to have a rectangular shape having a size of 300 mm × 100 mm with the use of a Thomson blade so that the long side thereof extended in the absorption axis direction of the polarizer. Then, as shown in FIG. 9, the circularly polarizing plate was subjected to irregularly-shaped-processing by forming a bathtub-shaped cutout and a round-shaped (semicircular) cutout at one of the long sides and the other long side, respectively with the use of an end mill. The radius of curvature of curved portion of the cutout was set to 10 mm.

### [Comparative Example 2]

### <Production of retardation layer>

### (Production of quarter wave plate)

A film was formed using a polycarbonate resin ("DURABIO" manufactured by Mitsubishi Chemical Corporation) and subjected to free-end uniaxial stretching. This stretched film (quarter wave plate) was a positive A plate having refractive index anisotropy of nx > ny = nz and had a thickness of 20 µm, an Re(450) of 143 nm, an Re(550) of 140 nm, and an Re(650) of 137 nm.

### (Production of half wave plate)

The thickness and stretched ratio of the above film were changed to obtain a stretched film (half wave plate) having a thickness of 40 µm, an Re(450) of 277 nm, an Re(550) of 270 nm, and an Re(650) of 265 nm.

### (Production of pressure sensitive adhesive sheet)

To a reaction vessel, 92 parts by weight of butyl acrylate, 5 parts by weight of N-acryloylmorpholine, 2.9 parts by weight of acrylic acid, and 0.1 parts by weight of 2-hydroxyethyl acrylate as monomers and 0.1 parts by weight of azobisisobutyronitrile as a polymerization initiator were added together with ethyl acetate, and the resultant was reacted at 55°C for 8 hours in a nitrogen gas stream. Thereafter, ethyl acetate was added to the reaction liquid to obtain a solution of an acryl-based polymer having a weight-average molecular weight of 1,780,000. To this solution, 0.15 parts by weight of dibenzoylperoxide ("NYPER BMT" manufactured by NOF Corporation) and 0.6 parts by weight of a trimethylolpropane/tolylene diisocyanate adduct ("CORONATE L" manufactured by Tosoh Corporation) were added as a crosslinker based on 100 parts by weight of the polymer to obtain a pressure sensitive adhesive composition. This pressure sensitive adhesive composition was applied onto a release-treated surface of a 38-µm-thick polyethylene terephthalate film ("MRF38" manufactured by Mitsubishi Chemical Corporation), and was dried and crosslinked at 150°C to prepare a pressure sensitive adhesive sheet A having a thickness of 5 µm.

### <Production of circularly polarizing plate>

The above half wave plate was bonded to the acryl-based film-side surface of the polarizing plate. An angle between the absorption axis direction of the polarizer and the stretching direction (slow axis direction) of the half wave plate was set to 75°. Then, the quarter wave plate was bonded to the surface of the half wave plate with the pressure sensitive adhesive sheet A being interposed therebetween. An angle between the absorption axis direction of the polarizer and the stretching direction (slow axis direction) of the quarter wave plate was set to 15°. Then, a 23-µm-thick acryl-based pressure sensitive adhesive sheet was bonded onto the quarter wave plate. In this way, a pressure sensitive adhesive-equipped circularly polarizing plate was obtained in which a pressure sensitive adhesive sheet was disposed on a laminate (circularly polarizing plate) wherein the circularly polarizing plate includes a half wave plate constituted from a stretched film laminated on a polarizing plate with a pressure sensitive adhesive layer being interposed therebetween and a quarter wave plate constituted from a stretched film laminated on the half wave plate with a pressure sensitive adhesive layer being interposed therebetween. This pressure sensitive adhesive-equipped circularly polarizing plate was subjected to irregularly-shaped-processing in the same manner as in Comparative Example 1.

### [Example 1]

### <Production of retarder>

### (Production of homogeneously-aligned liquid crystal layer)

55 parts by weight of a compound represented by the formula (I), 25 parts by weight of a compound represented by the formula (II), and 20 parts by weight of a compound represented by the formula (III) were added to and dissolved in 400 parts by weight of cyclopentanone by heating to 60°C with stirring, and then the resultant was cooled to room temperature to prepare a solution having a solid matter concentration of 20% by weight.

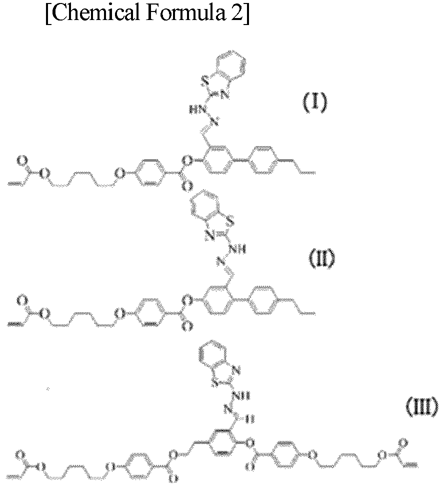

To this solution, 0.2 parts by weight of a levelling agent ("MEGAFACE F-554" manufactured by DIC Corporation), 3 parts by weight of a photopolymerization initiator (Omnirad 907), and 0.1 parts by weight of p-methoxyphenol were added to prepare a liquid crystalline composition solution.

A film substrate was prepared in which an alignment film subjected to rubbing treatment was provided on a triacetyl cellulose film. The above liquid crystalline composition was applied onto the alignment film of the film substrate by spin coating and heated at 100°C for 2 minutes to align the liquid crystal. After cooled to room temperature, the resultant was irradiated with ultraviolet light having an accumulated light amount of 900 mJ/cm² in a nitrogen atmosphere to perform photo-curing so that a laminate B was obtained in which a homogeneously-aligned liquid crystal layer (thickness 3 µm) was formed on the film substrate. This homogeneously-aligned liquid crystal layer was a positive A plate having refractive index anisotropy of nx > ny = nz. Obtained homogeneously-aligned liquid crystal layer was transferred onto a glass plate to measure front retardation. The front retardation Re(450), the front retardation Re(550), and the front retardation Re(650) were 118 nm, 145 nm, and 152 nm, respectively.

### (Bonding between homogeneously-aligned liquid crystal layer and homeotropically-aligned liquid crystal layer)

The aligned liquid crystal layer-side surface of each of the laminate A and the laminate B was subjected to corona treatment, the adhesive composition A was then applied, and the laminate A and the laminate B were bonded together by a roll laminator. Then, the resultant was irradiated with 700 mJ/cm² of ultraviolet light using a UV curing device (V valve) manufactured by Fusion UV Systems to cure the adhesive. In this way, a laminated retardation layer was obtained in which the homeotropically-aligned liquid crystal layer and the homogeneously-aligned liquid crystal layer were bonded together with the adhesive layer being interposed therebetween.

### <Production and processing of circularly polarizing plate>

The film substrate was removed by peeling from the surface of the homogeneously-aligned liquid crystal layer of the laminated retardation layer, and the acryl-based film-side surface of the polarizing plate was bonded to the exposed surface of the homogeneously-aligned liquid crystal layer with a 20-µm-thick acryl-based pressure sensitive adhesive sheet being interposed therebetween. An angle between the absorption axis direction of the polarizer and the alignment direction (slow axis direction) of the homogeneously-aligned liquid crystal layer was set to 45°. Then, the film substrate was removed by peeling from the surface of the homeotropically-aligned liquid crystal layer, and a 23-µm-thick acryl-based pressure sensitive adhesive sheet was bonded to the exposed surface of the homeotropically-aligned liquid crystal layer. In this way, a pressure sensitive adhesive-equipped circularly polarizing plate was obtained in which a pressure sensitive adhesive sheet was disposed on a laminate (circularly polarizing plate) wherein the circularly polarizing plate includes a homogeneously-aligned liquid crystal layer laminated on a polarizing plate with a pressure sensitive adhesive layer being interposed therebetween and a homeotropically-aligned liquid crystal layer laminated on the homogeneously-aligned liquid crystal layer with an adhesive layer being interposed therebetween. This pressure sensitive adhesive-equipped circularly polarizing plate was subjected to irregularly-shaped-processing in the same manner as in Comparative Example 1.

### [Example 2]

### <Production of retardation layer>

### (Production of homogeneously-aligned liquid crystal layer (quarter wave plate))

A photopolymerizable liquid crystal compound ("Paliocolor LC242" manufactured by BASF) exhibiting a nematic liquid crystal phase was dissolved in cyclopentanone to prepare a solution having a solid matter concentration of 30% by weight. To this solution, a levelling agent ("BYK-360" manufactured by BYK-Chemie) and a photopolymerization initiator (Omnirad 907) were added to prepare a liquid crystalline composition solution. The amount of the levelling agent added and the amount of the polymerization initiator added were respectively 0.01 parts by weight and 3 parts by weight based on 100 parts by weight of the photopolymerizable liquid crystal compound.

As a film substrate, a biaxially-stretched norbornene-based film ("ZeonorFilm" manufactured by Zeon Corporation, thickness: 33 µm) was used. The above liquid crystalline composition was applied onto the surface of the film substrate with a bar coater so that the thickness of the liquid crystalline composition after drying was 1 µm, and was heated at 100°C for 3 minutes to align the liquid crystal. After cooled to room temperature, the resultant was irradiated with ultraviolet light having an accumulated light amount of 400 mJ/cm² in a nitrogen atmosphere to perform photo-curing so that a laminate C was obtained in which a homogeneously-aligned liquid crystal layer (thickness 1 µm) was formed on the film substrate. This homogeneously-aligned liquid crystal layer was a positive A plate having refractive index anisotropy of nx > ny = nz. Obtained homogeneously-aligned liquid crystal layer was transferred onto a glass plate to measure front retardation. The front retardation Re(450), the front retardation Re(550), and the front retardation Re(650) were 156 nm, 144 nm, and 138 nm, respectively.

### (Production of homogeneously-aligned liquid crystal layer (half wave plate))

In the same manner as described above except that the thickness of the liquid crystal composition applied was changed, a laminate D was obtained in which a homogeneously-aligned liquid crystal layer having a thickness of 2 µm, Re(450) of 300 nm, Re(550) of 280 nm, and Re(650) of 268 nm was formed on a film substrate.

### <Production of circularly polarizing plate>

The acryl-based film-side surface of the polarizing plate was bonded to the aligned liquid crystal layer-side surface of the laminate D with a 20-µm-thick acryl-based pressure sensitive adhesive sheet being interposed therebetween. An angle between the absorption axis direction of the polarizer and the alignment direction (slow axis direction) of the homogeneously-aligned liquid crystal layer (half wave plate) was set to 75°. Then, the film substrate was removed by peeling from the surface of the homogeneously-aligned liquid crystal layer, and the homogeneously-aligned liquid crystal layer-side surface of the laminate C was bonded to the exposed surface of the homogeneously-aligned liquid crystal layer with the pressure sensitive adhesive sheet A being interposed therebetween. An angle between the absorption axis direction of the polarizer and the alignment direction (slow axis direction) of the homogeneously-aligned liquid crystal layer (quarter wave plate) was set to 15°. Then, the film substrate was removed by peeling from the surface of the homogeneously-aligned liquid crystal layer, and a 23-µm-thick acryl-based pressure sensitive adhesive sheet was bonded. In this way, a pressure sensitive adhesive-equipped circularly polarizing plate was obtained in which a pressure sensitive adhesive sheet was disposed on a laminate (circularly polarizing plate) wherein the circularly polarizing plate includes a homogeneously-aligned liquid crystal layer (half wave plate) laminated on a polarizing plate with a pressure sensitive adhesive layer being interposed therebetween and a homogeneously-aligned liquid crystal layer (quarter wave plate) laminated on the homogeneously-aligned liquid crystal layer with a pressure sensitive adhesive layer being interposed therebetween. This pressure sensitive adhesive-equipped circularly polarizing plate was subjected to irregularly-shaped-processing in the same manner as in Comparative Example 1.

### [Evaluations]

### <Retardation change>

The pressure sensitive adhesive sheet arranged on the surface of retardation layer of the pressure sensitive adhesive-equipped polarizing plate of each of Examples and Comparative Examples was bonded to a glass plate to prepare an evaluation sample. At seven positions (1) to (7) shown in FIG. 9, front retardations (initial values) at a wavelength of 550 nm were measured using a retardation meter ("KOBRA 21-ADH" manufactured by Oji Scientific Instruments Co., Ltd.) in elliptical polarization measurement mode. Then, the evaluation sample was placed in an air circulation-type thermostatic oven at 95°C, and the front retardations of the evaluation sample were measured after 240 hours.

A difference ΔRe between the maximum and minimum front retardations and a standard deviation σ which were determined by measuring the front retardations of the sample at 7 positions after the heat endurance test at 95°C for 240 hours are shown in Table 1.

**[Table 1]**

| | Configuration of retardation layer | | ΔRe | σ |
|---|---|---|---|---|
| Comparative Example 1 | Stretched film (reverse wavelength dispersion λ/4, 45°) | Homeotropically- aligned liquid crystal layer | 11.5 | 4.2 |
| Comparative Example 2 | Stretched film (λ/2, 75°) | Stretched film (λ/4, 15°) | 10.8 | 4.2 |
| Example 1 | Homogeneously-aligned liquid crystal layer (reverse wavelength dispersion λ/4, 45°) | Homeotropically- aligned liquid crystal layer | 6.3 | 2.1 |
| Example 2 | Homogeneously-aligned liquid crystal layer (λ/2, 75°) | Homogeneously-aligned liquid crystal layer (λ/4, 15°) | 5.9 | 2.2 |

### <Change in hue of reflected light>

An evaluation sample obtained by bonding, to a glass plate, the pressure sensitive adhesive sheet arranged on the surface of the retardation layer of each of the circularly polarizing plates of Comparative Example 1 and Example 2 was placed on an aluminum vapor-deposited film (manufactured by Toray Industries, Inc.) in such a manner that the glass plate-side surface was located on the lower side. White light was allowed to enter the circularly polarizing plate from the polarizing plate side, and the hue of reflected light was measured using a spectrophotometric colorimeter ("CM-26" manufactured by KONICA MINOLTA, INC.). The measurement was performed at seven positions (1) to (7) shown in FIG. 9. After the evaluation sample was subjected to a heat endurance test at 95°C for 240 hours, the hue of reflected light was again measured at the seven positions.

FIG. 10A and FIG. 10B are graphs each obtained by plotting the hue of reflected light before the heat test (A) and the hue of reflected light after the heat endurance test (∘) on an a*b* hue plane. In FIGS. 10A and 10B, the horizontal axis represents a* and the vertical axis represents b*.

After the heat endurance test, the in-plane variation of front retardation of each of the circularly polarizing plates of Examples 1 and 2 using the homogeneously-aligned liquid crystal layer as a positive A plate is smaller than that of each of the circularly polarizing plates of Comparative Examples 1 and 2 using the stretched film as a positive A plate, which indicates that the circularly polarizing plates of Examples 1 and 2 are small in variation of the hue of reflected light and have uniform properties.

### DESCRIPTION OF REFERENCE SIGNS

1 polarizing plate
10 polarizer
11, 12 transparent protective film
3 retardation layer
31 retardation layer (homogeneously-aligned liquid crystal layer)
32 retardation layer (homogeneously-aligned liquid crystal layer)
33 retardation layer (homogeneously-aligned liquid crystal layer)
36 retardation layer (homeotropically-aligned liquid crystal layer)
101, 102, 103, 105 elliptically polarizing plate
50 image display cell
201 image display device

## Claims

1. An elliptically polarizing plate comprising:
a polarizing plate including a polarizer, a first transparent protective film bonded to a first principal surface of the polarizer, and a second transparent protective film bonded to a second principal surface of the polarizer; and
a retardation layer bonded onto the first transparent protective film of the polarizing plate,
the elliptically polarizing plate being a sized piece having an irregularly shape that is not a rectangle in its plan view,
wherein
an angle between an absorption axis direction of the polarizer and a slow axis direction of the retardation layer is 10 to 80°,
the polarizer has a thickness of 15 µm or more,
the retardation layer satisfies Re(450) < Re(550) < Re(650), wherein Re(450) represents a front retardation at a wavelength of 450 nm, Re(550) represents a front retardation at a wavelength of 550 nm, and Re(650) represents a front retardation at a wavelength of 650 nm, and
the retardation layer includes at least one aligned liquid crystal layer in which liquid crystal molecules are homogeneously aligned.

2. The elliptically polarizing plate according to claim 1, wherein
the retardation layer includes two or more aligned liquid crystal layers, and
at least one of the aligned liquid crystal layers is an aligned liquid crystal layer in which liquid crystal molecules are homogeneously aligned.

3. The elliptically polarizing plate according to claim 1, wherein the retardation layer includes an aligned liquid crystal layer in which liquid crystal molecules are homogeneously aligned and an aligned liquid crystal layer in which liquid crystal molecules are homeotropically aligned.

4. The elliptically polarizing plate according to claim 1, wherein the retardation layer includes two or more aligned liquid crystal layers in which liquid crystal molecules are homogeneously aligned, and an angle between slow axis directions of the aligned liquid crystal layers is 10 to 80°.

5. An on-vehicle image display device comprising:
an image display cell; and
the elliptically polarizing plate according to any one of claims 1 to 4 disposed on a viewing-side surface of the image display cell.

6. The on-vehicle image display device according to claim 5, wherein the image display cell is an organic light emitting diode cell.
